# EUROPÄISCHE PATENTSCHRIFT

(11) **EP 1 153 535 B1**
(45) Veröffentlichungstag und Bekanntmachung des Hinweises auf die Patenterteilung: **11.09.2002**
(21) Anmeldenummer: 00909026.7
(22) Anmeldetag: 09.02.2000
(51) Int. Cl.: H05K 13/00, H05K 13/04

(54) **VORRICHTUNG ZUM BESTÜCKEN VON SUBSTRATEN MIT ELEKTRISCHEN BAUELEMENTEN**
DEVICE FOR PLACING ELECTRIC COMPONENTS ON SUBSTRATES
DISPOSITIF PERMETTANT DE DEPOSER DES COMPOSANTS ELECTRONIQUES SUR DES SUBSTRATS

(30) Priorität: 26.02.1999 DE 19908432
(43) Veröffentlichungstag der Anmeldung: 14.11.2001
(73) Patentinhaber: SIEMENS AKTIENGESELLSCHAFT, 80333 München (DE)
(72) Erfinder: RODERER, Helmut, D-82515 Wolfratshausen (DE)
(86) Internationale Anmeldenummer: DE0000390
(87) Internationale Veröffentlichungsnummer: WO00052985

(56) Entgegenhaltungen:
- EP-A- 0 391 707
- EP-A- 0 730 396
- US-A- 5 517 748
- PATENT ABSTRACTS OF JAPAN vol. 017, no. 528 (E-1437), 22. September 1993 (1993-09-22) & JP 05 145297 A (TOKICO LTD), 11. Juni 1993 (1993-06-11)

## Beschreibung

Die Erfindung bezieht sich auf eine Vorrichtung zum Bestücken von Substraten mit elektrischen Bauelementen, wobei die Substrate auf einem breitenverstellbaren Lineartransport verschiebbar sind.

Eine Vorrichtung mit allen im Oberbegriff des Anspruchs 1 genannten Merkmalen ist aus dem Dokument US-A-5 517 748 bekannt.

Es ist üblich, den Lineartransport mit zwei Teiltransporten und zwei schmalen Transportriemen zu versehen, auf denen die z.B. als Leiterplatten ausgebildeten Substrate mit ihren Randbereichen aufliegen. Die Transportbreite kann durch Verstellen des Abstands zwischen den beiden Teiltransporten auf die Substratbreite abgestimmt werden. Dabei ist es üblich, eine Seite auf einem Chassis der Bestückvorrichtung zu fixieren und die andere Seite verschiebbar zu lagern.

Zu beiden Seiten des Lineartransports sind Zuführmodule angeordnet, die auf einem tischartigen Träger fixiert sind. Bei einem Wechsel des zu bestückenden Leiterplattentyps ist es üblich, die Zuführmodule in ihrer Gesamtheit zu wechseln, indem ein anderer Träger mit vorbereiteten Zuführmodulen auf dem Chassis fixiert wird, wobei die Zuführmodule unabhängig von der Substratbreite eine stets gleichbleibende Lage einnehmen.

Insbesondere bei sehr schmalen Substraten vergrößert sich auf der verstellbaren Seite des Lineartransports der Abstand zwischen den Abholstellen der Zuführmodule und dem Substrat entsprechend.

Der Erfindung liegt die Aufgabe zugrunde, die Bestückleistung der Bestückvorrichtung zu erhöhen.

Diese Aufgabe wird durch die Erfindung gemäß Anspruch 1 gelöst. Durch die Verstellbarkeit des Trägers ist es möglich, diesen auch bei sehr schmalen Substraten nahe an den Lineartransport heranzusetzen, wodurch sich der Abstand zwischen dem Substrat und den Zuführmodulen verringert. Ein zwischen den Zuführmodulen und dem Substrat verfahrender Bestückkopf braucht dann nur entsprechend kürzere Wege zurückzulegen, was mit einer beträchtlichen Zeitersparnis verbunden ist.

Durch eine vorteilhafte Weiterbildung der Erfindung nach Anspruch 2 kann der auf der beweglichen Seite befindliche Träger ohne manuellen Eingriff zusammen mit dem beweglichen Teiltransport verschoben werden und nimmt dann immer einen gleichbleibend engen Abstand zu diesem ein.

Durch die Weiterbildung nach Anspruch 3 ist es mit geringem Umrüstaufwand möglich, den Teiltransport entweder auf der einen oder der anderen Seite gegenüber dem Chassis zu fixieren und die jeweils andere Seite verschiebbar zu machen. Durch die starre Kopplung zwischen dem Träger und der jeweiligen Seite des Lineartransportes ergibt sich eine feste Zuordnung zwischen den Trägern und dem ihnen zugewandten Teilpransport. Das bedeutet, daß leicht wechselbar jeweils eine Seite fixiert und die andere frei verschiebbar ist.

Bei der Herstellung von bestückten Leiterplatten ist es üblich, mehrere Geräte in einer Linie hintereinander anzuordnen. Dabei kann es vorkommen, daß Geräte unterschiedlicher Hersteller eingesetzt werden, bei denen die festen Seiten des Lineartransports unterschiedlich orientiert sind. Durch die Wechselbarkeit der festen und der variablen Seite ist es möglich, sich derartigen unterschiedlichen Verhältnissen anzupassen.

Im folgenden wird die Erfindung anhand eines in der Zeichnung dargestellten Ausführungsbeispieles näher erläutert.
- Figur 1: zeigt schematisiert eine Seitenansicht eines Ausschnitts aus einer Bestückvorrichtung,
- Figur 2: eine Draufsicht auf die Bestückvorrichtung nach Figur 1.

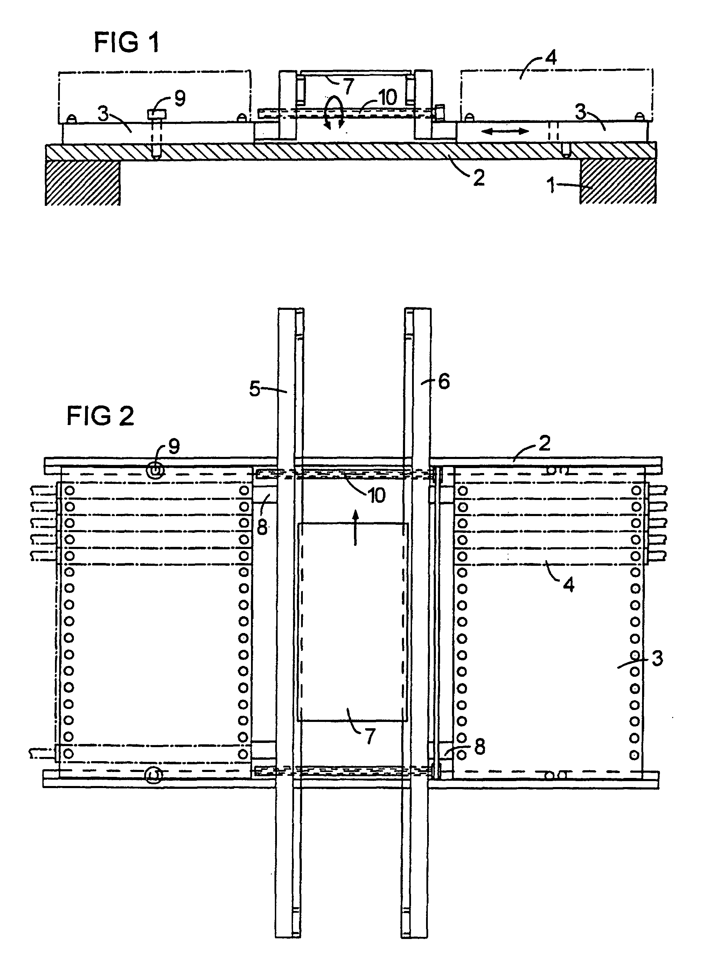

Nach den Figuren 1 und 2 ist an einem Chassis 1 einer Bestückvorrichtung eine Gleitbahn 2 für zwei tischartige Träger 3 befestigt, an deren Oberseite schmale Zuführmodule 4 für elektrische Bauelemente aneinandergereiht sind. Zwischen den zu einander parallel stehenden Trägern 3 ist ein zur Gleitbahn senkrecht gerichteter Lineartransport 5,6 angeordnet, auf dem ein plattenförmiges Substrat 7 aufliegt, das mittels eines nicht dargestellten Bestückkopfes mit den bereitgestellten Bauelementen.bestückt werden soll.

Der Lineartransport 5,6 besteht aus einem festen Teiltransport 5 und einem verstellbaren Teiltransport 6. Die beiden Teiltransporte 5,6 sind mit den ihnen jeweils benachbarten Trägern 3 mittels Verbindungsstücken 8 fest verbunden. Die Träger 3 und die Gleitbahn 2 sind mit Zentrierbohrungen 11 versehen. Der dem festen Teiltransport 5 zugeordnete Träger 3 ist mittels in die Zentrierbohrungen 11 eingesteckter stiftartiger Zentrierelemente 9 auf der Gleitbahn 2 fixiert. Damit ist auch der Teiltransport 5 festgelegt.

Die beiden Teiltransporte 5,6 sind mittels zweier Spindeln 10 in ihrem Abstand verstellbar. Der andere Träger 3 ist in der zum Lineartransport 5,6 senkrecht stehenden Gleitbahn 2 verschiebbar geführt. Die Verstellbewegung des rechten Teiltransportes 6 überträgt sich durch das Verbindungsstück 8 auf den zugehörigen Träger 3, der somit die Verstellbewegung des Teiltransports 6 nachvollzieht und zu diesem einen stets gleichbleibenden engen Abstand aufweist.

Die Zentrierbohrungen 11 des verschiebbaren Trägers 3 und der Gleitbahn 2 können auch auf der rechten Seite des Lineartransports 4,5 mittels der Zentrierelemente 9 zur Deckung gebracht werden können, wodurch der zugeordnete Teiltransport 5 gegenüber dem Chassis festgelegt wird. Auf der anderen Seite des Lineartransportes 5,6 werden die Zentrierelemente entfernt werden, wodurch diese Seite frei verschiebbar wird.

## Patentansprüche

1. Vorrichtung zum Bestücken von Substraten (7) mit elektrischen Bauelementen,
wobei die Substrate (7) auf einem breitenverstellbaren Lineartransport (5,6) verschiebbar sind,
wobei die Bauelemente an Zuführmodulen (4) bereitgestellt und von einem Bestückkopf abholbar sind,
wobei die Zuführmodule (4) zu beiden Seiten des Lineartransports (5,6) auf tischartigen Trägern (3) fixierbar sind, die auf einem Chassis (1) der Vorrichtung lösbar befestigt sind,
**dadurch gekennzeichnet,**
**daß** zumindest einer der Träger (3) am Chassis zum gegenüberliegenden Träger (3) hin verstellbar angebracht ist.

2. Vorrichtung nach Anspruch 1,
**dadurch gekennzeichnet,**
**daß** der Lineartransport aus zwei zueinander im Abstand verstellbaren Teiltransporten (5,6) gebildet ist,
**daß** der verstellbare Träger (3) auf einer zum Lineartransport senkrechten Gleitbahn (2) des Chassis (1) gelagert und stufenlos verstellbar ist, und
**daß** dieser Träger (3) mechanisch fest mit dem verstellbaren Teiltransport (6) gekoppelt ist.

3. Vorrichtung nach Anspruch 2,
**dadurch gekennzeichnet,**
**daß** beide Träger (3) auf der Gleitbahn (2) gelagert und wahlweise mittels Zentrierelementen am Chassis (1) fixierbar sind,
**daß** der jeweils nicht fixierte Träger (3) auf der Gleitbahn (2) stufenlos verstellbar gelagert ist, und
**daß** beide Träger (3) fest mit dem zugehörigen Teiltransport (5,6) gekoppelt sind.

## Claims

1. Device for placing electric components on substrates (7),
it being possible for the substrates (7) to be displaced on an adjustable-width linear transport means (5, 6),
it being possible for the components to be provided on feed modules (4) and collected by a placement head,
it being possible for the feed modules (4) to be fixed, on both sides of the linear transport means (5, 6), on table-like carriers (3), which are detachably fixed to a chassis (1) of the device,
**characterized in that** at least one of the carriers (3) is fitted to the chassis such that it can be adjusted towards the opposite carrier (3).

2. Device according to Claim 1, **characterized**
**in that** the linear transport means is formed by two part transport means (5, 6) that can be adjusted at a distance from one another,
**in that** the adjustable carrier (3) is mounted on a sliding track (2) of the chassis (1), perpendicular to the linear transport, and can be adjusted continuously, and
**in that** this carrier (3) is mechanically firmly connected to the adjustable part transport means (6).

3. Device according to Claim 2, **characterized**
**in that** both carriers (3) are mounted on the sliding track (2) and can be fixed as desired by means of centring elements on the chassis (1),
**in that** the respectively unfixed carrier (3) is mounted such that it can be adjusted continuously on the sliding track (2), and
**in that** both carriers (3) are firmly coupled to the associated part transport means (5, 6).

## Revendications

1. Dispositif pour déposer des composants électriques sur des substrats (7), les substrats (7) étant déplaçables sur un transport linéaire (5, 6) réglable en largeur, les composants étant mis à disposition sur des modules d'alimentation (4) et pouvant être retirés par une tête de mise en place, les modules d'alimentation (4) pouvant être fixés des deux côtés du transport linéaire (5, 6) sur des supports (3) en forme de table fixés de manière amovible sur un châssis (1) du dispositif, **caractérisé**
**en ce qu'**au moins un des supports (3) est amené sur le châssis de manière réglable par rapport au support (3) opposé.

2. Dispositif selon la revendication 1, **caractérisé**
**en ce que** le transport linéaire est formé de deux transports partiels (5, 6) réglables l'un par rapport à l'autre en écartement,
**en ce que** le support réglable (3) est placé sur une glissière (2) du châssis (1) perpendiculaire au transport linéaire et est réglable en continu, et
**en ce que** ce support (3) est couplé mécaniquement de manière fixe au transport partiel (6) réglable.

3. Dispositif selon la revendication 2, **caractérisé**
**en ce que** les deux supports (3) sont placés sur la glissière (2) et, au choix, peuvent être fixés sur le châssis (1) au moyen d'éléments de centrage,
**en ce que** le support (3) respectivement non fixé est monté réglable en continu sur la glissière (2), et
**en ce que** les deux supports (3) sont couplés de manière fixe au transport partiel (5, 6) correspondant.
